# DEMANDE DE BREVET EUROPEEN

(11) **EP 0 772 315 A1**
(43) Date de publication de la demande: **07.05.1997**
(21) Numéro de dépôt: 95402454.3
(22) Date de dépôt: 03.11.1995
(51) Int. Cl.: H04K 3/00

(54) **Procédé et dispositif de transmission radioélectrique protégé contre le bruit**

(71) Demandeur: THOMSON-CSF, 75008 Paris (FR)
(72) Inventeur: Giraudo, Michel, Thomson-CSF, SCPI, F-92402 Courbevoie Cedex (FR)
(74) Mandataire: Lincot, Georges

(57) **Abrégé**

L'invention concerne les procédés de protection contre le brouillage des récepteurs radioélectriques.

Elle consiste, en présence d'un brouilleur de barrage affectant la transmission d'une porteuse normalement modulée en fréquence, a transmettre celle-ci sans modulation de fréquence mais modulée par tout ou rien à faible cadence. La démodulation s'effectue en testant l'accrochage d'une boucle de phase (201) par un circuit dit de VITERBI (301) dont une sortie (M) indique l'état de verrouillage ou de non verrouillage de la boucle de phase et représente donc la modulation appliquée à la porteuse.

Elle permet en sacrifiant la cadence de transmission de transmettre un minimum d'informations entre un émetteur et récepteur.

## Description

La présente invention se rapporte aux procédés qui permettent de protéger contre le bruit, notamment contre les brouillages, les systèmes de transmission radioélectriques. Elle concerne également les dispositifs émetteurs et récepteurs qui permettent de mettre en oeuvre ce procédé.

L'une des méthodes connues pour brouiller les liaisons radio d'un réseau, dite à brouilleur intelligent, consiste à brouiller sélectivement les canaux de fréquence utilisés dans ce réseau. Pour déterminer ces fréquences, on utilise un récepteur panoramique qui analyse le spectre de toute la bande utilisée par le réseau et on repère les canaux utilisés, à l'aide d'un certains nombres de critères tel que la localisation ou le niveau.

Pour se prémunir contre de tels brouillages un moyen consiste à procéder à des sauts de fréquence, selon une loi de répartition dans le temps et en fréquence connue des seules stations du réseau, mais qui apparait comme aléatoire pour le brouilleur Cette méthode, dite à évasion de fréquence, est aussi utile pour se protéger contre la localisation par goniométrie et pour renforcer le secret des communications.

Une autre méthode de brouillage, dite à brouilleur de barrage, consiste à brouiller en permanence toute la bande utilisée par le réseau au moyen d'un émetteur modulé par un bruit blanc dont la largeur de spectre permet d'émettre sur un niveau sensiblement constant sur toute la bande désirée. Cette méthode présente l'inconvénient d'une part de perturber aussi les liaisons radio utilisées du côté du brouilleur et d'autre part de nécessiter un émetteur puissant et bien dégagé, placé par exemple à bord d'un avion.

Pour transmettre un minimun d'informations en présence d'un brouilleur de barrage, l'invention propose de moduler à vitesse lente par tout ou rien la porteuse d'un émetteur et d'extraire cette modulation à la réception par le circuit d'indication de verrouillage d'une boucle à verrouillage de phase accrochée sur la porteuse.

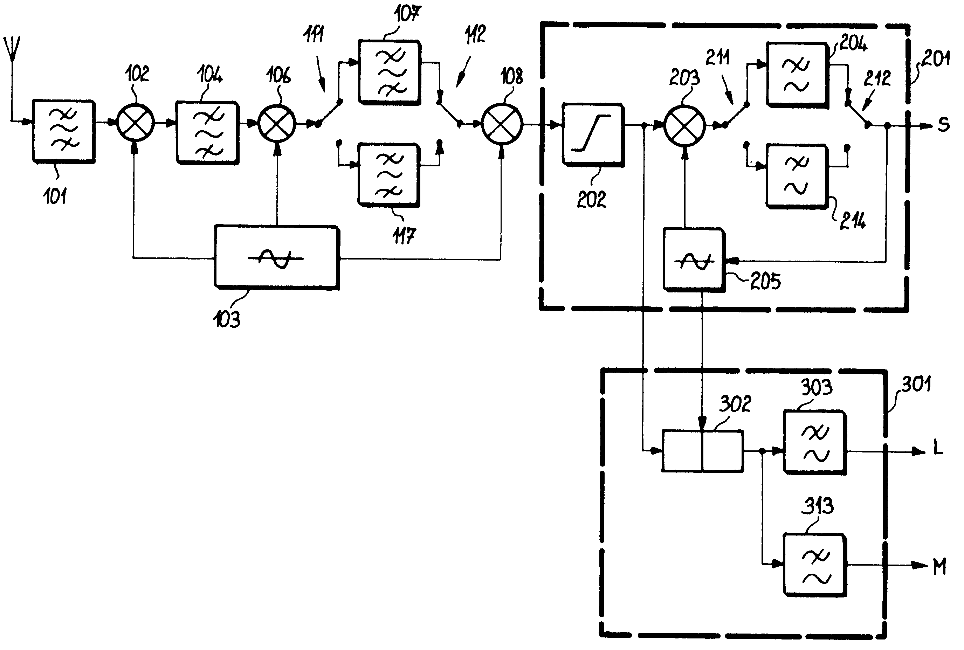

D'autres particularités et avantages de l'invention apparaîtront clairement dans la description suivante, présentée à titre d'exemple non limitatif et faite en regard de la figure annexée qui représente le schéma synoptique d'un récepteur radio à modulation de fréquence modifié pour détecter les signaux protégés contre le bruit selon le procédé de l'invention.

A titre d'exemple on utilise un poste récepteur de radio conçu pour recevoir dans des conditions normales une émission à seize kilobits/s codée en NRZ et transmise par modulation de fréquence d'une porteuse dans la bande 30 - 88 MHz avec une excursion de ± 15 KHz, ce qui correspond à une bande passante FI de 36 KHz environ.

Dans ces conditions on a déterminé que pour transmettre un minimun d'informations en dépit de la présence d'un brouilleur de barrage on pouvait, selon l'invention, moduler par tout ou rien la porteuse en code NRZ à une vitesse de 25 bits/s.

Les signaux provenant de l'antenne sont filtrés par un filtre passe-bande 101 entre 30 et 88 MHz.

Les signaux ainsi filtrés sont transposés à 112 MHz à l'aide d'un mélangeur 102 alimenté par un oscillateur local 103.

Après filtrage par un premier filtre FI 104, les signaux sont de nouveau transposés à 14,8 MHz dans un mélangeur 106 alimenté par l'oscillateur 103. Après filtrage par un deuxième filtre FI 107, les signaux sont finalement transposés sur une fréquence finale à 0,4 MHz par un mélangeur 108 alimenté par l'oscillateur 103.

Après ces trois transpositions, le signal est démodulé dans un démodulateur à boucle de phase 201.

Pour cela, il est d'abord écrêté dans un limiteur 202, puis appliqué avec les signaux d'un oscillateur contrôlé en tension 205, à un détecteur de phase 203.

Le signal de sortie de ce détecteur est proportionnel à l'écart de fréquence ou de phase par rapport à 0,4 MHz, et représente donc la modulation en fréquence de la porteuse. Il est filtré dans un filtre passe-bas 204 qui, d'une part délivre cette modulation sur une sortie S, et d'autre part commande la fréquence de l'oscillateur 205. La largeur de bande du filtre 204 est de 36 KHz, valeur adaptée au rythme de la modulation.

Pour savoir si la boucle de phase est bien accrochée, information essentielle pour une bonne réception, on utilise un circuit 301 connu sous le nom de circuit de VITERBI.

Ce circuit comprend une bascule du type D 302 dont l'entrée d'horloge est alimentée par une sortie de l'oscillateur 205 délivrant un signal de même fréquence que celui qui alimente le mélangeur 203 mais déphasé de 90° par rapport à celui-ci.

Par ailleurs l'entrée de données de cette bascule 302 reçoit le signal en sortie du limiteur 202.

Ainsi cette bascule échantillonne le signal démodulé par la boucle de phase, sur le front montant du signal d'horloge déphasé fourni par l'oscillateur 205. De ce fait elle se positionne sur un niveau 1 ou 0 selon que cet échantillonnage se produit sur le palier supérieur ou inférieur du signal rectangulaire délivré par le limiteur. Lorsque la boucle de phase est bien verrouillée, ce signal est le même que celui fourni par l'oscillateur 205 au détecteur 203 et il est donc en quadrature avec le signal fourni par ce même oscillateur à l'entrée d'horloge de la bascule 302. Dans ces conditions, l'échantillonnage a toujours lieu sur le même palier, par exemple le palier supérieur, et la bascule se maintient dans un état constant, par exemple l'état 1. La sortie de la bascule est donc dans un état 1 constant, c'est à dire avec une tension constante.

Quand la boucle de phase décroche, par exemple parce que le niveau de signal reçu est insuffisant, le signal de l'oscillateur 205 ne suit plus le signal fournit par le limiteur 202, et l'échantillonnage de ce dernier signal a lieu aussi bien sur les paliers supérieurs que sur les paliers inférieurs. Dans ces conditions la bascule 302 change régulièrement d'état, et la tension moyenne sur sa sortie baisse jusqu'à une valeur minimum, égale à la moitié de la tension correspondante à l'accrochage lorsque les signaux de réception et de l'oscillateur 205 sont totalement décorrelés. Pour obtenir un niveau de sortie sans fluctuations et exploitable, on filtre le signal de sortie de la bascule 302 par un filtre passe-bas 301 qui délivre le signal de verrouillage ou de non verrouillage sur une sortie L. Pour obtenir une bonne indication, par exemple l'allumage d'un voyant, la bandepassante de ce filtre 303 est de quelques Hz, typiquement 1 Hz.

Lorsque la réception est brouillée, la boucle de phase décroche et les signaux sur la sortie S deviennent incohérents, ce qui se manifeste notamment par l'extinction du voyant alimenté par la sortie L.

Pour assurer dans ces conditions un minimum de réception, on commute alors le récepteur en mode protection contre le bruit.

Pour cela à l'aide de deux commutateurs 111 et 112 on substitue un troisième filtre FI 117 au filtre 107. La largeur de bande de ce filtre est réduite au maximum pour permettre de transmettre le spectre résultant de la modulation en tout ou rien à la cadence de 25 bits/s. De manière pratique cette largeur de bande est un peu plus grande, de l'ordre de 1 KHz, afin de pallier un certains nombres d'imperfections diverses, telles que les dérives des oscillateurs tant de l'émetteur que du récepteur. Ce filtre permet déjà de rejeter une partie importante du bruit provenant du brouilleur.

On substitue ensuite au filtre de boucle 204, à l'aide des commutateurs 211 et 212, un autre filtre 214 dont la fréquence de coupure est adaptée à la modulation, soit 50 Hz environ pour une modulation de 25 bits/s. Il est clair que ce filtre ne permet pas d'obtenir sur la sortie S la modulation, mais permet de maintenir le verrouillage de la boucle sur les paliers correspondants à la transmission de la porteuse. En dehors de ces paliers la boucle décroche.

Dans ces conditions le circuit de VITERBI 301 peut délivrer un signal qui représente la modulation par tout ou rien de la porteuse, puisqu'il signale l'accrochage et le décrochage de la boucle de phase, c'est à dire la présence ou l'absence de la porteuse.

Toutefois pour éviter que le filtre 303, destiné à lisser le signal de sortie pour indiquer l'accrochage à un opérateur, ne supprime cette modulation, on connecte la sortie de la bascule 302 à un filtre passe-bas 313 à fréquence de coupure plus haute, 13 Hz dans l'exemple décrit. Ce filtre délivre sur une sortie M la modulation transmise malgré le brouillage.

En fait l'efficacité du circuit de VITERBI est telle que le niveau de sortie passe assez progressivement entre sa valeur nominale et la valeur moitié lorsque la boucle de phase décroche petit à petit. On peut donc en fixant un seuil intermédiaire entre ces deux valeurs démoduler des signaux extrêmement brouillés pour lesquels le verrouillage de phase ne s'effectue qu'imparfaitement pendant les instants de transmission de la porteuse.

Le procédé selon l'invention permet donc de transmettre des messages numériques à cadence lente avec un très haut degré de résistance au bruit en général, et plus particulièrement à celui dû au brouillage de barrage.

Il est tout à fait compatible avec les méthodes de saut de fréquence et il s'applique en modifiant de manière tout à fait minime les récepteurs à modulation de fréquence équipés d'un démodulateur à boucle de phase. Le volume d'un tel récepteur n'est pas augmenté, ni pratiquement son poids.

## Revendications

1. Procédé de transmission radioélectrique protégé contre le bruit, dans lequel on transmet une porteuse modulée en fréquence et on la démodule à l'aide d'une boucle de phase (201), caractérisé en ce qu'en présence de bruit on module par tout ou rien à faible cadence cette porteuse sans la moduler en fréquence, et qu'on la démodule en testant (301) l'état d'accrochage de la boucle de phase (201).

2. Procédé selon la revendication 1, caractérisé en ce que l'on utilise pour tester l'état d'accrochage de la boucle de phase (201) un circuit de VITERBI (301).

3. Procédé selon l'une quelconque des revendications 1 et 2, caractérisé en ce que la porteuse est dans la bande 30-88 MHz et que la cadence de modulation par tout ou rien est sensiblement de 25 bits/s.

4. Dispositif d'émission pour la mise en oeuvre du procédé selon l'une quelconque des revendications 1 à 3, caractérisé en ce qu'il comprend des moyens permettant d'interrompre la transmission de la porteuse.

5. Dispositif de réception pour la mise en oeuvre du procédé selon l'une quelconque des revendications 1 à 3, caractérisé en ce qu'il comprend des moyens (111,112) pour substituer à un filtre FI adapté à la transmission en modulation de fréquence, un filtre FI (117) à bande étroite adaptée à la modulation par tout ou rien à faible cadence de la porteuse, des moyens (211,212) pour substituer à un filtre (204) adapté à l'accrochage de la boucle de phase en présence de la modulation de fréquence, un filtre (214) de boucle à bande étroite adaptée à la modulation à faible cadence, et un filtre (313) connecté à la sortie de la bascule (302) du circuit de VITERBI, ce dernier filtre ayant une bande passante suffisante pour laisser passer la modulation à faible cadence.

6. Dispositif selon la revendication 5, caractérisé en ce que le filtre FI (117) adapté à la réception à faible cadence a une largeur de bande de 1 KHz, que le filtre de boucle (214) adapté à cette réception a une largeur de bande de 50 Hz, et que le filtre de sortie (313) du circuit de VITERBI a une largeur de bande de 13 Hz.
